# EUROPÄISCHE PATENTSCHRIFT

(11) **EP 1 386 400 B1**
(45) Veröffentlichungstag und Bekanntmachung des Hinweises auf die Patenterteilung: **18.04.2007**
(21) Anmeldenummer: 02737835.5
(22) Anmeldetag: 08.05.2002
(51) Int. Cl.: H03L 7/187

(54) **PHASENREGELSCHLEIFE**
PHASE LOCKED LOOP
BOUCLE A PHASE ASSERVIE

(30) Priorität: 08.05.2001 DE 10122194
(43) Veröffentlichungstag der Anmeldung: 04.02.2004
(73) Patentinhaber: Infineon Technologies AG, 81669 München (DE)
(72) Erfinder: BALM, Bart, 6531 Nijmegn (NL); MEVISSEN, Walter, 40227 Düsseldorf (DE)
(74) Vertreter: Epping - Hermann - Fischer
(86) Internationale Anmeldenummer: PCT/DE2002/001674
(87) Internationale Veröffentlichungsnummer: WO 2002/091580

(56) Entgegenhaltungen:
- EP-A- 0 412 491
- WO-A-89/06456
- DE-A- 19 938 515
- GB-A- 2 282 285
- PATENT ABSTRACTS OF JAPAN vol. 006, no. 264 (E-150), 23. Dezember 1982 (1982-12-23) -& JP 57 160227 A (FUJITSU KK), 2. Oktober 1982 (1982-10-02)

## Beschreibung

Die vorliegende Erfindung betrifft eine Phasenregelschleife.

Phasenregelschleifen, englisch PLL, Phase-Locked-Loop, werden beispielsweise in Sende- und Empfangseinheiten im Mobilfunk eingesetzt.

Zur Bereitstellung eines Vielfachzugriffs für mehrere Teilnehmer an einer gemeinsamen Basisstation sowie zur Bereitstellung von vollduplexfähigen System kann zum einen ein Senden und Empfangen in Zeitschlitzen und zum anderen ein Frequenzsprungverfahren, Frequency Hopping, eingesetzt sein.

Um zugleich eine einfache Modulation zu ermöglichen, können sogenannte Open-Loop-Verfahren benutzt werden, welche eine Direktmodulation, On-Frequency-Modulation, unmittelbar in der Phasenregelschleife beziehungsweise unmittelbar im spannungsgesteuerten Oszillator der Phasenregelschleife ermöglichen. Dabei wird während der Modulation, das heißt während eines Sende-Zeitschlitzes, die Rückkopplung der Phasenregelschleife aufgehoben. Anschließend wird, um auf eine neue Trägerfrequenz beziehungsweise auf einen neuen Kanal einschwingen zu können, die Rückkopplung der Phasenregelschleife wieder hergestellt und somit der Regelkreis wieder geschlossen.

Während des offenen Betriebes der Phasenregelschleife kann jedoch das Problem auftreten, daß die Trägerfrequenz, auf die die PLL eingeschwungen ist, zeitabhängigen Drifts unterworfen ist. Diese Drifts können beispielsweise durch eine Änderung der Abstimmspannung des Schleifenfilters in der PLL verursacht sein. Da die Größe sowie die Richtung derartiger Drifts abhängig ist von der zuvor benutzten Frequenz der Phasenregelschleife, wird dieser Drift.oft als sogenannter Memory-Effekt bezeichnet.

Eine der Hauptursachen für einen derartigen Memory-Effekt ist die dielektrische Absorption der PLL-Schleifenfilterkondensatoren in Zusammenhang mit der Veränderung der Abstimmspannung bei einem Kanalwechsel. Die Abstimmspannung, welche eingangsseitig am spannungsgesteuerten Oszillator eines Frequenzregelkreises anliegt, ist normalerweise gleich der Spannung an Schleifenfilterkondensatoren im Regelkreis, welche unter anderem für eine stabile Regelung sorgen. Die dielektrische Absorption des Kondensatordielektrikums, die sogenannte Capacitor Soakage, ist ein ursprünglich aus der Hochspannungstechnik bekannter Effekt. Kondensatoren mit Öl-Papier-Dielektrikum, welche beispielsweise durch Kurzschließen entladen wurden, weisen nach Entfernen der Kurzschlußverbindung und dem anschließenden Verstreichen einiger Zeit wieder eine beträchtliche Spannung zwischen den Elektroden auf. Diese Problematik stellt ein zunehmendes Problem in analogen Schaltkreisen, wie Abstast-Haltschaltungen, integrierenden Analog/Digital-Konvertern und aktiven Filtern dar.

Die beschriebene Problematik der dielektrischen Absorption in Open-Loop-Frequency-Hopping-Systemen kann beispielsweise dadurch verringert werden, daß hochwertige, teuere Schleifenfilterkondensatoren eingesetzt werden, welche eine geringe dielektrische Absorption haben. Neben den höheren Kosten haben derartige Kondensatoren jedoch bei gleichem Kapazitätswert den weiteren Nachteil einer sehr großen Bauform, welche insbesondere der im Mobilfunk bestehenden Forderung nach kleinen und leichten Geräten entgegensteht. Aber selbst durch Verwendung derart hochwertiger Schleifenfilterkondensatoren kann die dielektrische Absorption lediglich verringert, nicht jedoch vollständig verhindert werden.

In dem Dokument US 4,074,209 ist eine Phasenregelschleife mit vergrößerter Modulationsbandbreite angegeben. Das Frequenzmodulationssignal wird dabei nicht nur dem Phasenkomparator der Phasenregelschleife, sondern auch dem spannungsgesteuerten Oszillator zugeführt. Hierfür sind parallel zum eigentlichen Schwingkreis Varaktoren geschaltet. Diese zur Modulation dienenden zusätzlichen Varaktoren werden mit einem Bias-Signal kompensiert in Abhängigkeit von der gewählten Frequenz.

In dem Dokument EP 0 412 491 A ist ein Frequenzsynthesizer, der eine Phasenregelschleife (PLL) und einen zusätzlichen Regelkreis aufweist, angegeben. Die PLL enthält einen mit einer ersten und einer zweiten Varaktordiode versehenen spannungsgesteuerten Oszillator. Um eine Verringerung der Einrastzeit der PLL bei Frequenzwechseln durchzuführen, werden aus einer Speicherschaltung ausgelesene Spannungsdaten durch einen Digital-Analog-Wandler der zweiten Varaktordiode zugeführt.

Aufgabe der vorliegenden Erfindung ist es, eine Phasenregelschleife anzugeben, welche in Open-Loop-Frequency-Hopping-Systemen einsetzbar ist und bei der mit geringem Aufwand eine Verringerung oder eine Kompensation des beschriebenen Memory-Effekts ermöglicht ist.

Erfindungsgemäß wird die Aufgabe mit einer Phasenregelschleife gelöst, aufweisend die Merkmale des Patentanspruchs 1.

Dem beschriebenen Gegenstand liegt dabei das Prinzip zugrunde, daß zum weitgehenden Konstanthalten der Abstimmspannung in der Regelschleife das ohnehin der Phasenregelschleife, genauer dem Frequenzteiler in der Regelschleife zuzuführende

Frequenzwort zur Vorgabe der Soll-Frequenz oder des Soll-Kanals zusätzlich einem weiteren Abstimmeingang des spannungsgesteuerten Oszillators in der Phasenregelschleife zugeführt ist.

Bei dem beschriebenen Gegenstand erfolgt eine Kompensation des Memory-Effektes der Schleifenfilterkondensatoren in der Phasenregelschleife mittels Resonanzfrequenzvorwahl des spannungsgesteuerten Oszillators.
Der zweite Abstimmeingang des Oszillators, dem das Frequenzwort zur Kanalwahl übermittelt wird, dient bei dem beschriebenen Gegenstand zur Verringerung der Veränderung der Abstimmspannung bei einem Kanalwechsel der Phasenregelschleife. Aufgrund der Kennlinie der Frequenz in Abhängigkeit von der Abstimmspannung eines spannungsgesteuerten Oszillators muß ohne den beschriebenen zweiten Abstimmeingang jeder Wechsel des Kanals zwischen zwei Zeitschlitzen, beispielsweise bei einem Frequenzsprungverfahren, zu einer Veränderung der Abstimmspannung führen.

Bei der beschriebenen Anordnung hingegen kann mittels des zweiten Abstimmeingangs, dem das Frequenzwort zur Kanalwahl übermittelt ist, eine Kompensation derart erfolgen, daß beispielsweise bei einer Kanalerhöhung die wirksamen Kapazitäten im Oszillator verringert werden und dadurch insgesamt trotz des Kanalwechsels die Abstimmspannung nahezu oder vollständig konstant bleiben kann. Eine geringe oder eine verschwindende Abweichung der Abstimmspannung zwischen zwei aufeinanderfolgenden Zeitschlitzen wiederum vermeidet jedoch den eingangs beschriebenen Memory-Effekt der Schleifenfilterkondensatoren, die üblicherweise in einer Phasenregelschleife eingesetzt sind. Hierdurch ist der Frequenzdrift in einem Open-Loop-Betrieb der Phasenregelschleife signifikant verringert.

Die vorliegende Erfindung ist demnach besonders zur Direktmodulation in Open-Loop-Systemen geeignet, wie sie beispielsweise bei Frequenzsprungverfahren, welche zur Bereitstellung von Vollduplex mit Zeitschlitzen arbeiten, vorkommen. Der geringe Frequenzdrift während des offenen Betriebes der Phasenregelschleife ist dabei mit besonders einfachen Mitteln und demnach kostengünstig erzielbar.

Gemäß der vorliegenden Erfindung weist der spannungsgesteuerte Oszillator eine mit dem zweiten Abstimmeingang steuerbare, frequenzbestimmende Kapazität auf.

Spannungsgesteuerte Oszillatoren können beispielsweise als LC-Schwingkreise, umfassend eine Induktivität und eine Kapazität zur Bildung eines schwingungsfähigen Systems, ausgeführt sein. In diesem Fall ist es, da einfacher realisierbar, üblich, die Schwingkreiskapazität zum Einstellen der Frequenz des Schwingkreises steuerbar auszuführen. Da spannungsgesteuerte Oszillatoren mit lediglich einem Abstimmeingang ohnehin üblicherweise eine abstimmbare Kapazität, beispielsweise eine Varaktordiode, aufweisen, ist zur Realisierung der beschriebenen Phasenregelschleife ein weiteres, steuerbares und frequenzbestimmendes Element, hier eine Kapazität, vorzusehen.

In einer bevorzugten Ausführungsform der vorliegenden Erfindung umfaßt die Phasenregelschleife einen Phasendetektor, der mit einem Eingang an den Ausgang des Frequenzteilers, mit einem weiteren Eingang mit einer Bezugsfrequenzquelle und ausgangsseitig über einen Schleifenfilter an den ersten Abstimmeingang des Oszillators angeschlossen ist.

Der Phasendetektor, welcher das Ausgangssignal des VCO mit einer Bezugsfrequenz vergleicht und in Abhängigkeit von einer Phasen- und/oder Frequenzabweichung der beiden Signale am Ausgang ein Signal bereitstellt, welches in einer Regelschleife dem ersten Abstimmeingang des VCO zugeführt wird, ist ebenso wie das Schleifenfilter zur Gewährleistung einer Stabilität der Regelschleife üblicherweise in Phasenregelschleifen vorgesehen. Die Besonderheit bei vorliegendem Gegenstand ist jedoch, daß Kapazitäten im Schleifenfilter, welche beispielsweise zu Integrationszwecken eingesetzt sind, aufgrund der auch bei Kanalwechseln weitgehend konstanten Abstimmspannung einen deutlich geringeren oder keinen Memory-Effekt zeigen.

Das Schleifenfilter kann dabei insbesondere zur Gewährleistung der Stabilität des Regelkreises vorgesehen, sein.

Die Bezugsfrequenzquelle kann als Referenzoszillator mit einem nachgeschalteten Frequenzteiler ausgebildet sein.

Neben der bereits beschriebenen, analogen Realisierung der steuerbaren Kapazität ist auch eine Abstimmung in diskreten Schritten in vorteilhafter Weise möglich, hierzu können beispielsweise jeweils Serienschaltungen aus einer Kapazität und einem Schalter miteinander parallel verschaltet sein. Hier-durch ist eine Kapazitätsbatterie gebildet. Eine derartige steuerbare Kapazität ist zwar nicht stufenlos verstellbar, läßt sich aber besonders einfach in einer integrierten Schaltung ausführen. Besonders vorteilhaft kommt eine mit zu- oder abschaltbaren Teilkapazitäten steuerbare Kapazität dann zum Einsatz, wenn das Frequenzwort zur Vorgabe der Frequenz der Phasenregelschleife ohnehin als digitaler Wert vorliegt. Die Stufung ist so ausgeführt, daß die relative Änderung der Kapazität jeweils zur relativen Änderung des Frequenzwortes zur Kanalwahl analog ausgeführt ist, das heißt, daß die Teilkapazitäten so abgestuft sind, wie auch die mit dem Frequenzwort einstellbaren Kanäle zuein-ander abgestuft sind. Hierdurch ist eine besonders einfache und kostengünstige Ansteuerung der steuerbaren Kapazität mit dem Frequenzwort zur Vorgabe oder Programmierung der Soll-Frequenz der Phasenregelschleife möglich.

In einer weiteren, bevorzugten Ausführungsform der vorliegenden Erfindung ist zur Übermittlung des Frequenzwortes ein Datenbus vorgesehen, der die Frequenzvorgabeeinheit mit dem Steuereingang des Frequenzteilers und mit dem zweiten Abstimmeingang des Oszillators verbindet. Das Frequenzwort kann dabei beispielsweise 3 Bit umfassen.

Weitere Einzelheiten der Erfindung sind Gegenstand der Unteransprüche.

Die Erfindung wird nachfolgend an zwei Ausführungsbeispielen anhand der Zeichnungen näher erläutert.

Es zeigen:
- Figur 1: ein Ausführungsbeispiel anhand eines vereinfachten Blockschaltbildes und
- Figur 2: ein Ausführüngsbeispiel der vorliegenden Erfindung anhand eines vereinfachten Blockschaltbildes.

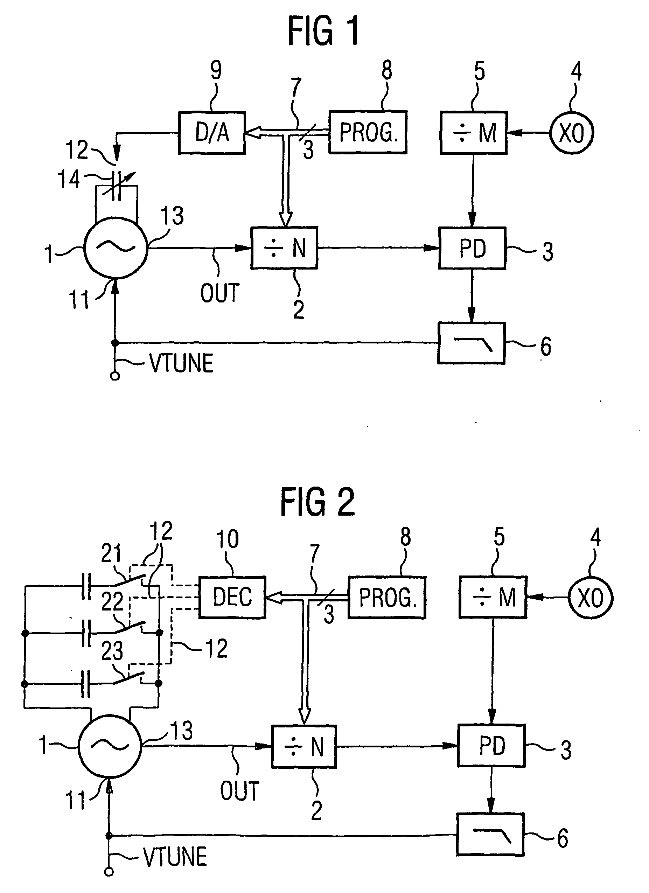

Figur 1 zeigt einen spannungsgesteuerten Oszillator 1 mit einem ersten Abstimmeingang 11 und mit einem zweiten Ab-stimmeingang 12. Am ersten Abstimmeingang 11 ist die Abstimmspannung VTUNE zuführbar, welche in der Phasenregelschleife gewonnen wird. Am Ausgang 13 des spannungsgesteuerten Oszillators 1 ist ein Signal OUT mit einer abstimmbaren Frequenz ableitbar. Diese gesteuerte Frequenz des Ausgangssignals OUT am Ausgang 13 wird dabei zum einen vom am ersten Abstimmeingang 11 anliegenden Signal beeinflußt, zum anderen aber auch von dem am zweiten Abstimmeingang 12 anliegenden Signal.

Zur Bildung einer herkömmlichen Phasenregelschleife ist der Ausgang 13 des Oszillators 1 über einen programmierbaren Frequenzteiler 2, der das Ausgangssignal des Oszillators frequenzmäßig herunterteilt, an einen Phasendetektor 3 eingangsseitig angeschlossen. Der Phasendetektor 3 vergleicht die Frequenz des frequenzgeteilten Ausgangssignals des Oszillators 1 mit der Frequenz eines Referenzsignals, welches von einem Referenzoszillator 4 bereitgestellt und ebenfalls in einem Frequenzteiler 5 frequenzgeteilt ist. Der Phasendetektor 3 stellt an seinem Ausgang ein Signal bereit, welches von der Differenz der beschriebenen Eingangssignale abhängt. Über ein Schleifenfilter 6, welches die Stabilität des Regelkreises sicherstellt, ist der Ausgang des Phasendetektors 3 an den ersten Abstimmeingang 11 des Oszillators 1 angeschlossen. Ausgangsseitig am Schleifenfilter 6 ist dabei die Abstimmspannung VTUNE der Phasenregelschleife bereitgestellt.

Die Frequenzvorgabe für die Phasenregelschleife gemäß Figur 1 ist durch Vorgabe des Teilerverhältnisses des Frequenzteilers 2 im Regelkreis einstellbar. Hierfür weist der Frequenzteiler 2 einen Steuereingang auf, der an einen Datenbus 7 zur Übermittlung eines digital codierten Frequenzwortes angeschlossen ist. Der Datenbus 7 weist eine Breite von 3 bit auf. Zur Übermittlung des Frequenzwortes ist der Datenbus 7 an den Ausgang einer Frequenzvorgabeeinheit 8 angeschlossen, welche in dem Frequenzwort, welches vom Datenbus 7 zu übermitteln ist, den Kanal, auf den die Phasenregelschleife einschwingen soll, als Sollwert bereitstellt.

Die Besonderheit bei der vorliegenden Schaltung gemäß Figur 1 ist, daß das ohnehin vorhandene PLL-Frequenzwort neben der Steuerung des Teilerverhältnisses des Frequenzteilers 2 zusätzlich einem zweiten Abstimmeingang 12 des spannungsgesteuerten Oszillators 1 zugeführt wird. Hierfür ist der Ausgang der Frequenzvorgabeeinheit 8 über den Datenbus 7 nicht nur an den Steuereingang des Frequenzteilers 2 angeschlossen, sondern auch mittels des Datenbusses 7 mit dem zweiten Abstimmeingang 12 des spannungsgesteuerten Oszillators 1 gekoppelt. Im vorliegenden Blockschaltbild ist über den Abstimmeingang 12 eine als Varaktordiode ausgebildete Kapazität stufenlos einstellbar. Die Varaktordiode ist dabei mit dem Bezugszeichen 14 versehen. Da die Varaktordiode 14 stufenlos einstellbar ist und zu ihrer Ansteuerung demnach ein analoges Spannungssignal erfordert, ist zur Kopplung des Datenbusses 7 mit dem Steuereingang der Varaktordiode 14 ein Digital/Analog-Konverter 9 vorgesehen. Dieser wandelt das digitale 3-Bit-Wort, welches an seinem Eingang, der an den Ausgang der Frequenzvorgabeeinheit 8 angeschlossen ist, bereitsteht, in ein analoges Spannungssignal an seinem Ausgang um, der mit dem Steuereingang der Varaktordiode 14 verbunden ist.

Die Resonanzfrequenzvorwahl des spannungsgesteuerten Oszillators 1 durch Übermittlung des Frequenzwortes mit dem Datenbus 7 erfolgt so, daß die Änderung der Abstimmspannung VTUNE bei einer Änderung des Frequenzwortes und damit des Teilerverhältnisses im Frequenzteiler 2 verschwindet oder möglichst gering ist. Beispielsweise bei einer Erhöhung der Frequenz beziehungsweise des Kanals würde normalerweise auch die Abstimmspannung VTUNE ansteigen, dieser Anstieg wird bei vorliegender Schaltung jedoch zumindest teilweise dadurch kompensiert, daß der wirksame Kapazitätswert der Varaktordiode 14 in Abhängigkeit vom Frequenzwort der Frequenzvorgabeeinheit 8 verringert wird. Die PLL-Schleifenfilterspannung bleibt demnach auch bei Umschalten auf die neue Frequenz nahezu konstant, so daß bei vorliegender Phasenregelschleife kein Spannungs- beziehungsweise Frequenzdrift im Open-Loop-Betrieb während eines Sende-Zeitschlitzes zu erwarten ist. Aufgrund der verbesserten Frequenzdrift-Eigenschaften können im Schleifenfilter 6 kleinere und/oder kostengünstigere Schleifenfilterkondensatoren eingesetzt sein, welche geringeren Anforderungen bezüglich des Memory-Effekts genügen müssen beziehungsweise welche schlechtere dielektrische Absorptionseigenschaften haben können. Der schaltungstechnische Aufwand zum Erzielen der beschriebenen Vorteile ist dabei, wie anhand von Figur 1 sichtbar, gering.

Die Kondensatorbatterie von Figur 2 umfaßt eine Parallelschaltung aus drei Zweigen, welche jeweils eine Serienschaltung aus einer abgestuften Kapazität und einem Schalter 21, 22, 23, der beispielsweise als Feldeffekttransistor ausgeführt sein kann, umfassen. Mit einem Decoder 10, dessen Eingang mit dem Ausgang der Frequenzvorgabeeinheit 8 über den Datenbus 7 verbunden ist, ist eine Umsetzung des Frequenzwortes zur Programmierung des Teilerverhältnisses des Frequenzteilers 2 in Steuersignale für die Schalter 21 bis 23 ermöglicht, wobei die Steuereingänge der Schalter 21 bis 23 mit Ausgängen des Decoders 10 unter Bildung des Abstimmeingangs 12 des Oszillators 1 verbunden sind. Der weitere Aufbau der Phasenregelschleife stimmt mit der bereits für Figur beschriebenen Schaltung mit Phasendetektor 3, Schleifenfilter 6 und Referenzoszillator 4 mit nachgeschaltetem Teiler 5 in Aufbau und Funktion überein und wir hier nicht noch einmal beschrieben.

Zusätzlich zu den bereits für Figur 1 genannten Vorteilen der Phasenregelschleife weist das Ausführungsbeispiel gemäß Figur 2 den zusätzlichen Vorteil der einfacheren Implementierung dadurch auf, daß eine digitale beziehungsweise diskrete Ansteuerung der diskret abgestuften Kapazitäten mit dem ohnehin digital vorliegenden Frequenzwort der Frequenzvorgabeeinheit 8 besonders einfach realisierbar ist. Zudem ist der Einsatz einer programmierbaren Kapazität, wie in Figur 2, insbesondere bei integriert ausgeführtem spannungsgesteuerten Oszillator und integrierter Phasenregelschleife einfacher realisierbar und weist zudem bessere VCO-Güten auf.

Zusätzlich zur in Figur 2 gezeigten Abstufung der Teilkapazitäten, in der gezeigten Kapazitätsbatterie ist auch eine Abstufung der einzelnen, zuschaltbaren Teilkapazitäten so möglich, daß eine der Kapazitätsabstufung entsprechende Frequenzänderung des Oszillators einer Änderung eines entsprechenden Bits im PLL-Frequenzwort entspricht, welches mit dem Bus 7 übertragbar ist. Mit einem derart ausgebildeten, spannungsgesteuerten Oszillator mit so abgestuften Teilkapazitäten ist mit besonders geringem Zusatzaufwand gegenüber bisherigen Phasenregelschleifen eine deutliche Verbesserung der Frequenzdrift-Eigenschaften möglich.

In Abwandlungen des beschriebenen Ausführungsbeispiels gemäß Figur 2 kann der Decoder 10 bei geeigneter Programmierung des Frequenzwortes sowie bei geeigneter Abstufung der umschaltbaren Teilkapazitäten auch entfallen.

Die beschriebenen Ausführungsbeispiele sind beispielsweise zur Direktmodulation in einem Open-Loop-Verfahren in TDD-, Time Division Duplex-, Mobilfunk-Systemen einsetzbar, welche Frequenzsprungverfahren unterstützen.

### Bezugszeichenliste

- 1: Spannungsgesteuerter Oszillator
- 2: Frequenzteiler
- 3: Phasendetektor
- 4: Referenz-Oszillator
- 5: Frequenzteiler
- 6: Schleifenfilter
- 7: Datenbus
- 8: Frequenzvorgabeeinheit
- 9: Digital/Analog-Konverter
- 10: Decoder
- 11: Abstimmeingang
- 12: Abstimmeingang
- 13: Ausgang
- 14: Varaktordiode
- 21: Schalter
- 22: Schalter
- 23: Schalter
- OUT: Ausgangssignal
- VTUNE: Abstimmspannung

## Patentansprüche

1. Phasenregelschleife für Open-Loop-Betrieb, aufweisend
- einen spannungsgesteuerten Oszillator (1) mit einem ersten Abstimmeingang (11) zur Zuführung einer Abstimmspannung (VTUNE) und mit einem Signalausgang (13) zur Bereitstellung eines Ausgangssignals (OUT) mit abstimmbarer Frequenz, wobei
- der spannungsgesteuerte Oszillator (1) eine mit einem zweiten Abstimmeingang (12) steuerbare, frequenzbestimmende Kapazität (14) aufweist, welche mehrere, jeweils zu- oder abschaltbare diskrete Teilkapazitäten umfaßt,
- einen Frequenzteiler (2) mit einstellbarem Teilerverhältnis zur Kanaleinstellung der Phasenregelschleife, mit einem Eingang, der mit dem Signalausgang (13) des Oszillators (1) gekoppelt ist, mit einem Ausgang, an dem ein frequenzgeteiltes Ausgangssignal ableitbar und der mit dem ersten Abstimmeingang (11) des Oszillators (1) in einer Regelschleife (3, 6) gekoppelt ist, und mit einem Steuereingang zur Vorgabe des Teilerverhältnisses (N), und
- eine Frequenzvorgabeeinheit (8) zur Programmierung der Frequenz des Ausgangssignals mit abstimmbarer Frequenz (OUT), die zum einen zur Übermittlung eines Frequenzwortes.mit dem Steuereingang des Frequenzteilers (2) und zum anderen zur Übermittlung des Frequenzwortes mit dem zweiten Abstimmeingang (12) des Oszillators (1) gekoppelt ist, derart, daß eine Änderung der Abstimmspannung (VTUNE) bei einer Änderung des Frequenzwortes verschwindet oder möglichst gering ist zur Vermeidung eines Frequenzdrifts in einem Open-Loop-Betrieb der Phasenregelschleife, wobei die Teilkapazitaten so abgestuft sind, wie auch die mit dem Frequenzwort einstellbaren Kanäle zueinander abgestuft sind.

2. Phasenregelschleife nach Anspruch 1,
**dadurch gekennzeichnet, daß** diese einen Phasendetektor (3) umfaßt, der mit einem Eingang an den Ausgang des Frequenzteilers (2), mit einem weiteren Eingang mit einer Bezugsfrequenzquelle (4, 5) und ausgangsseitig über ein Schleifenfilter (6) an den ersten Abstimmeingang (11) des Oszillators (1) angeschlossen ist.

3. Phasenregelschleife nach einem der vorhergehenden Ansprüche,
**dadurch gekennzeichnet, daß**
zur Übermittlung des Frequenzwortes ein Datenbus (7) vorgesehen ist, der die Frequenzvorgabeeinheit (8) mit dem Steuereingang des Frequenzteilers (2) und mit dem zweiten Abstimmeingang (12) des Oszillators (1) verbindet.

## Claims

1. Phase locked loop for open loop mode, having
- a voltage controlled oscillator (1) having a first tuning input (11) for supplying a tuning voltage (VTUNE) and having a signal output (13) for providing an output signal (OUT) of tunable frequency, where
- the voltage controlled oscillator (1) has a frequency-determining capacitor (14) which can be controlled using a second tuning input (12) and which comprises a plurality of discrete capacitor elements which can be respectively connected or disconnected,
- a frequency divider (2) having an adjustable division ratio for the purpose of channel adjustment for the phase locked loop, having an input which is coupled to the signal output (13) of the oscillator (1), having an output on which a frequency-divided output signal can be derived and which is coupled to the first tuning input (11) of the oscillator (1) in a control loop (3, 6), and having a control input for stipulating the division ratio (N), and
- a frequency stipulation unit (8) for programming the frequency of the output signal of tunable frequency (OUT) which is coupled firstly to the control input of the frequency divider (2) for the purpose of transmitting a frequency word and secondly to the second tuning input (12) of the oscillator (1) for the purpose of transmitting the frequency word such that a change in the tuning voltage (VTUNE) upon a change in the frequency word disappears or is as small as possible in order to avoid any frequency drift in an open loop mode of the phase locked loop, the capacitor elements being graduated in the same way as the channels which can be adjusted using the frequency word are graduated with respect to one another.

2. Phase locked loop according to Claim 1,
**characterized in that**
it comprises a phase detector (3), one input of which is connected to the output of the frequency divider (2), a further input of which is connected to a reference frequency source (4, 5) and the output side of which is connected via a loop filter (6) to the first tuning input (11) of the oscillator (1).

3. Phase locked loop according to one of the preceding claims,
**characterized in that**
a data bus (7) which connects the frequency stipulation unit (8) to the control input of the frequency divider (2) and to the second tuning input (12) of the oscillator (1) is provided for the purpose of transmitting the frequency word.

## Revendications

1. Boucle à phase asservie pour un fonctionnement en boucle ouverte, comprenant
- un oscillateur (1) commandé par la tension et ayant une première entrée (11) d'accord pour l'application d'une tension (VTUNE) d'accord et une sortie (13) de signal pour la mise à disposition d'un signal (OUT) de sortie d'une fréquence pouvant être accordée, dans laquelle
- l'oscillateur (1) commandé par la tension a une capacité (14) qui peut être commandée par une deuxième entrée (12) d'accord, qui détermine la fréquence et qui comprend plusieurs sous-capacités discrètes pouvant être respectivement mises en circuit ou hors circuit,
- un diviseur (2) de fréquence ayant un rapport de division réglable pour régler le canal de la boucle à phase asservie, comprenant une entrée qui est couplée à la sortie (13) pour le signal de l'oscillateur (1), une sortie à laquelle peut être prélevé un signal de sortie divisé en fréquence et qui est couplé à la première entrée (11) d'accord de l'oscillateur (1) dans une boucle (3, 6) d'asservissement, et ayant une entrée de commande pour la prescription du rapport (N) de division, et
- une unité (8) de prescription de fréquence pour la programmation du signal de sortie de fréquence (OUT) accordable et couplée d'une part, pour la transmission d'un mot de fréquence, à l'entrée de commande du diviseur (2) de fréquence et d'autre part, pour la transmission du mot de fréquence, à la deuxième entrée (12) d'accord de l'oscillateur (1) de façon à ce qu'une variation de la tension (VTUNE) d'accord lors d'une modification du mot de fréquence disparaisse ou soit aussi petite que possible pour éviter une dérive de fréquence dans un fonctionnement en boucle ouverte de la boucle à phase asservie, les sous-capacités étant échelonnées comme sont également échelonnés entre eux les canaux réglables par le mot de fréquence.

2. Boucle à phase asservie suivant la revendication 1,
**caractérisée en ce qu'**elle comprend un détecteur (3) de phase, qui est relié par une entrée à la sortie du diviseur (2) de fréquence, par une autre entrée à une source (4, 5) de fréquence de référence et du côté sortie à la première entrée (11) d'accord de l'oscillateur (1) par l'intermédiaire d'un filtre (6) à boucle.

3. Boucle à phase asservie suivant l'une des revendications précédentes,
**caractérisée en ce que**, pour la transmission du mot de fréquence, il est prévu un bus (7) de données, qui relie l'unité (8) de prescription de fréquence à l'entrée de commande du diviseur (2) de fréquence et à la deuxième entrée (12) d'accord de l'oscillateur (1).
